# EUROPÄISCHE PATENTSCHRIFT

(11) **EP 1 328 141 B1**
(45) Veröffentlichungstag und Bekanntmachung des Hinweises auf die Patenterteilung: **10.11.2010**
(21) Anmeldenummer: 03000373.5
(22) Anmeldetag: 10.01.2003
(51) Int. Cl.: H05K 1/18, B60Q 1/00, F21S 8/10

(54) **Baueinheit mit einer Leiterbahn aus flexiblem Material und Verfahren zur Herstellung einer solchen Baueinheit**
Assembly having a conductor from flexible material and method for manufacturing such an assembly
Assemblage ayant un conducteur en matériau flexible et procédé de fabrication d'un tel assemblage

(30) Priorität: 12.01.2002 DE 10200961; 20.12.2002 DE 10261771
(43) Veröffentlichungstag der Anmeldung: 16.07.2003
(73) Patentinhaber: odelo GmbH, 71409 Schwaikheim (DE); SMR Patents S.à.r.l., 1653 Luxembourg (LU)
(72) Erfinder: Schreck, Wolfgang, 73730 Esslingen (DE); Scholz, Jochen, 73547 Lorch (DE); Romberg, Andreas, Dr., 71522 Backnang (DE); Weber, Christine, 73728 Esslingen (DE)
(74) Vertreter: Jackisch-Kohl, Anna-Katharina

(56) Entgegenhaltungen:
- DE-A1- 4 423 888
- DE-A1- 10 018 807
- DE-A1- 10 025 563
- DE-A1- 19 853 899
- DE-A1- 19 958 605
- FR-A- 2 795 670
- JP-A- 9 260 433
- JP-A- 11 175 682
- JP-A- 58 117 234
- JP-A- 63 284 888
- US-A- 5 449 480
- US-A- 5 848 462
- US-A- 5 931 577
- US-A- 6 059 382
- US-B1- 6 321 443

## Beschreibung

Die Erfindung betrifft eine Baueinheit für den Einbau in ein Fahrzeug nach dem Oberbegriff des Anspruches 1 sowie ein Verfahren zur Herstellung einer solchen Baueinheit nach dem Oberbegriff des Anspruches 14.

Es ist beispielsweise bei Leuchteneinheiten für Kraftfahrzeuge bekannt, im Leuchtengehäuse einen Reflektor anzuordnen, der von LEDs ausgesandtes Licht nach außen reflektiert. Die LEDs sitzen auf einer flexiblen Leiterfolie. Die Montage der flexiblen Leiterbahn mit den LEDS ist aufwändig, da die LEDs innerhalb der Leuchteneinheit in eine genaue Einbauposition gebracht werden müssen. Dies ist infolge der Flexibilität der Leiterbahn schwierig.

Bei einer bekannten Baueinheit (DE 100 25 563 A1) wird die flexible Leiterbahn durch ein mechanisch flexibles metallisches Gitter gebildet, das so vorgeformt wird, wie es für den Einbau in einem Leuchtengehäuse erforderlich ist. Nach der Formung wird das metallische Gitter in das mechanisch stabilisierende Material eingegossen oder mit einem mechanisch stabilisierenden Material umspritzt.

Aus der FR-A-2 795 670 ist eine Baueinheit bekannt, die eine flexible Leiterplatte mit Bauelementen aufweist. Die flexible Leiterplatte wird einseitig plan von einem Kunststoffträger gestützt. Die integrierten Bauteile werden mit umgossen. Eine Herstellung von komplexen dreidimensionalen Strukturen ist damit nicht möglich.

Der Erfindung liegt die Aufgabe zugrunde, die gattungsgemäße Baueinheit und das gattungsgemäße Verfahren so auszubilden, dass die flexible Leiterbahn in einfacher Weise in einer gewünschten Einbaulage montiert werden kann.

Diese Aufgabe wird bei der gattungsgemäßen Baueinheit erfindungsgemäß mit den kennzeichnenden Merkmalen des Anspruches 1 und beim gattungsgemäßen Verfahren erfindungsgemäß mit den kennzeichnenden Merkmalen des Anspruches 14 gelöst.

Bei der erfindungsgemäßen Baueinheit ist die flexible Leiterbahn wenigstens teilweise in das Kunststoffteil eingebettet. Die flexible Leiterbahn wird durch eine flexible Leiterfolie gebildet, die durch die teilweise Einbettung in das Kunststoffteil ihre Formstabilität erhält. Darum muss die Leiterfolie bei der Montage der Baueinheit nicht gesondert montiert werden, sondern bildet zusammen mit dem formstabilen Kunststoffteil die Baueinheit, die einfach montiert werden kann. Die Leiterbahn ist im formbeständigen Bauteil vor Beschädigung geschützt.

Die Leiterbahn wird beim erfindungsgemäßen Verfahren zunächst mit dem elektronischen und/oder elektrischen Bauteil bestückt und anschließend in die Spritzgussform eingesetzt und dort lagegesichert. Als flexible Leiterbahn wird die flexible Leiterfolie eingesetzt, die zwischen wenigstens zwei Haltestempeln der Spritzgussform so eingespannt wird, dass der das elektrische und/oder elektronische Bauteil enthaltende Bereich der Leiterfolie innerhalb eines Hohlraums wenigstens des einen Haltestempels liegt. Die Leiterfolie wird dann wenigstens teilweise mit Kunststoff von beiden Seiten umspritzt. Der Hohlraum wird gegenüber dem in die Spritzgussform eingespritzten Kunststoff durch den Haltestempel abgedichtet. Nach dem Aushärten bzw. Erstarren des Kunststoffes kann die teilweise eingebettete Leiterbahn der Spritzgussform entnommen werden.

Weitere Merkmale der Erfindung ergeben sich aus den weiteren Ansprüchen, der Beschreibung und den Zeichnungen.

Die Erfindung wird anhand eines in den Zeichnungen dargestellten Ausführungsbeispieles näher erläutert. Es zeigen
- Fig. 1: im Schnitt einen Teil einer Leuchteneinheit als Baueinheit mit einer Leiterbahn,
- Fig. 2: in perspektivischer Darstellung einen Reflektor der Leuchteneinheit gemäß Fig. 1, an dem die Leiterbahn vorgesehen ist,

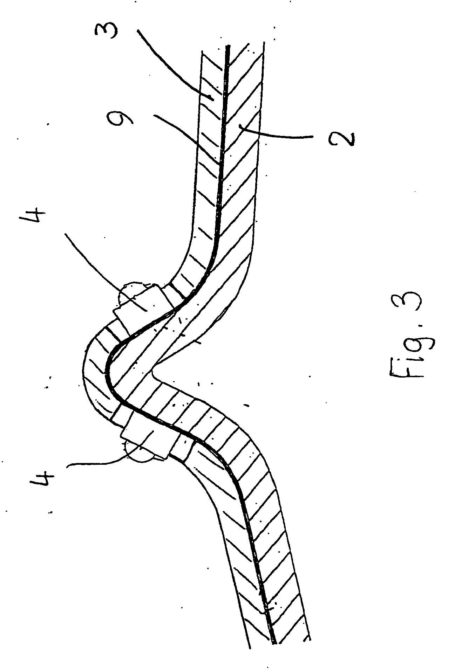

- Fig. 3: in vergrößerter Darstellung und im Schnitt einen Teil der Leiter- bahn,
- Fig. 4: im Schnitt und in vereinfachter Darstellung eine Spritzgussform zur Herstellung der erfindungsgemäßen Baueinheit,
- Fig. 5: eine weitere Baueinheit in einer Darstellung entsprechend Fig. 3.

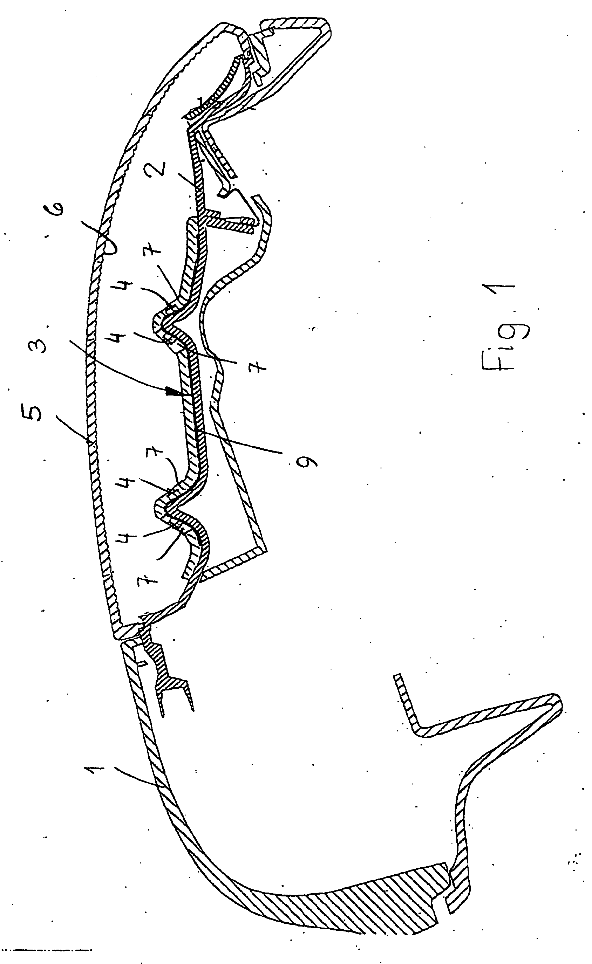

Fig. 1 zeigt eine Leuchteneinheit, die im Ausführungsbeispiel eine Rückleuchte eines Kraftfahrzeuges ist. Die Leuchteneinheit hat ein Gehäuse 1, in dem ein Träger 2 untergebracht ist. Er besteht vorzugsweise aus Kunststoff, kann aber aus jedem anderen geeigneten Material bestehen. Der Träger 2 ist mit einem Reflektor 3 einstückig ausgebildet, mit dem von Leuchtmitteln 4 ausgesandte Strahlen zu einer Lichtscheibe 5 reflektiert werden, durch die das Licht nach außen gelangt. Die Ausbildung einer solchen Rückleuchte von Kraftfahrzeugen ist bekannt und wird darum auch nicht näher beschrieben. Die Lichtscheibe 5 kann an ihrer Innenseite mit Leuchtoptiken 6 versehen sein.

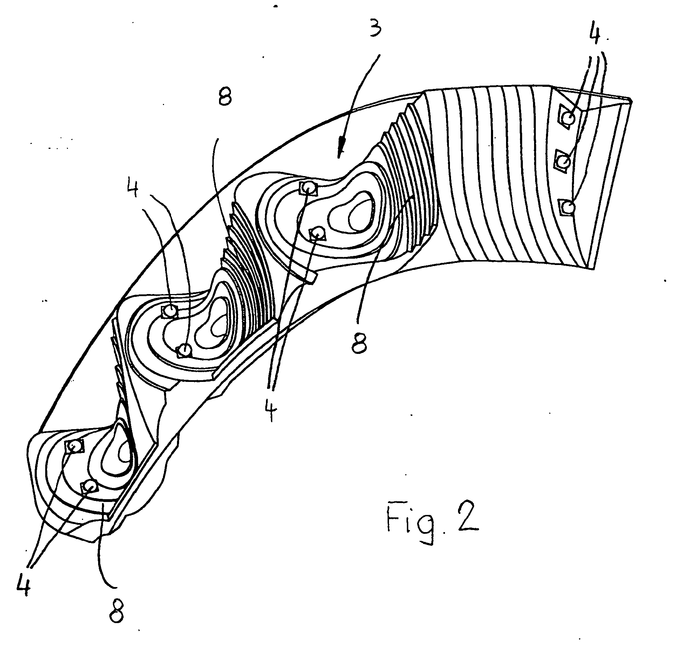

Der Reflektor 3 hat Öffnungen 7, in denen die Leuchtmittel 4 liegen. Der Reflektor 3 hat, wie Fig. 2 zeigt, für jedes Leuchtmittel 4 entsprechende Reflektorflächen 8. Die Leuchtmittel 4 sind vorteilhaft LEDs, die auf einer Leiterbahn 9 sitzen. Als Leuchtmittel 4 können auch SMD-LED's verwendet werden. Wie Fig. 2 zeigt, sind die Leuchtmittel 4 im Ausführungsbeispiel im Bereich der Reflektorflächen jeweils paarweise vorgesehen. Je nach Ausbildung des Reflektors 3 können auch mehrere solcher Leuchtmittel 4 der entsprechenden Reflektorfläche 8 zugeordnet sein. Ebenso ist es selbstverständlich möglich, für jede Reflektorfläche 8 nur ein einziges Leuchtmittel 4 vorzusehen. Im Ausführungsbeispiel sind seitlich drei weitere, mit Abstand nebeneinander liegende Leuchtmittel 4 vorgesehen, die ebenfalls vorteilhaft LEDs sind und die nicht durch die Lichtscheibe 4 abstrahlen, sondern quer hierzu.

Die Leiterbahn 9 ist eine flexible Leiterfolie, über die die Stromzuführung zu den Leuchtmitteln 4 in bekannter Weise erfolgt. Da die Leiterfolie 9 flexibel ist, kann sie an jede Form des Trägers 2 und/oder des Reflektors 3 angepaßt werden.

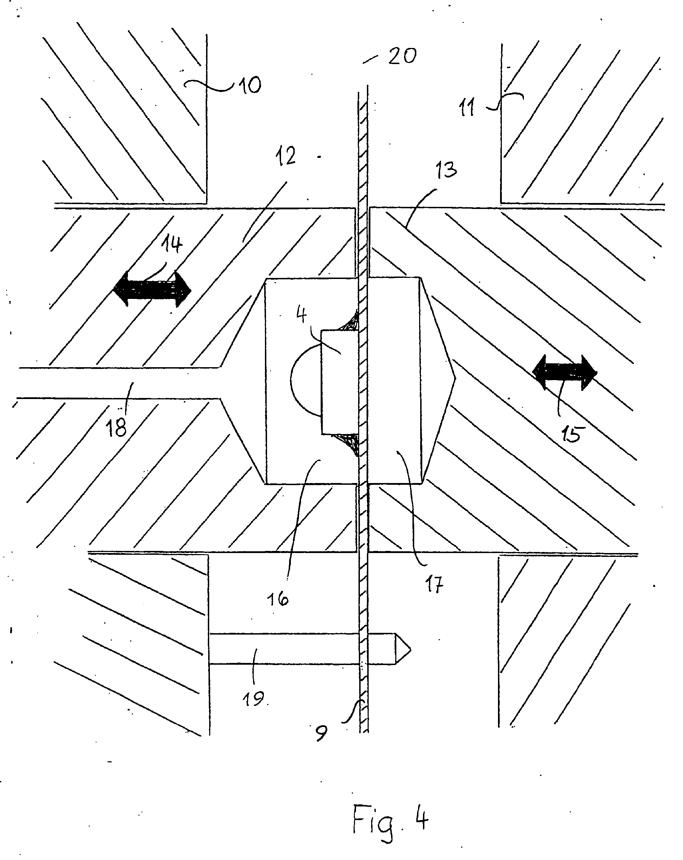

Der Träger 2 und der Reflektor 3 umschließen die Leiterbahn 9. Bei der Herstellung des Trägers 2 und des Reflektors 3 wird die Leiterbahn 9 vom Material dieser beiden Teile 2, 3 umspritzt. Dadurch ist die Leiterbahn 9 einwandfrei gesichert und geschützt. Fig. 4 zeigt schematisch einen Teil einer Spritzgußform. Sie hat zwei Formteile 10, 11, von denen das Formteil 10 fest und das Formteil 11 beweglich ist. Beide Formteile 10, 11 weisen jeweils wenigstens einen Haltestempel 12, 13 auf, die gegeneinander beweglich in den Formteilen 10, 11 angeordnet sind und zwischen denen die flexible Leiterbahn 9 während des Spritzgußvorganges eingeklemmt wird. Die beiden Haltestempel 12, 13 sind in Richtung der in Fig. 4 eingezeichneten Doppelpfeile 14, 15 verstellbar. Beide Haltestempel 12, 13 sind so ausgebildet, daß sie wenigstens einen Hohlraum 16, 17 aufweisen. Die beiden Hohlräume 16, 17 liegen einander gegenüber und bilden einen gemeinsamen, von der Leiterbahn 9 unterteilten Hohlraum. Er ist so ausgebildet, daß das auf der Leiterbahn 9 befestigte Leuchtmittel 4 während des Spritzgußvorganges aufgenommen werden kann. Die beiden Haltestempel 12, 13 klemmen die Leiterbahn 9 im Bereich neben dem Leuchtmittel 4 so, daß der in die Spritzgußform eingebrachte Kunststoff nicht in den Hohlraum 16, 17 eindringen kann.

Entsprechend der Zahl der Leuchtmittel 4, die auf der Leiterbahn 9 sitzen, sind Haltestempel mit entsprechenden Hohlräumen in der Spritzgußform vorgesehen.

In den Hohlraum 16 des einen Haltestempels 12 kann ein Vakuumkanal 18 münden, über den der Hohlraum während des Spritzgußvorganges unter Vakuum gesetzt werden kann.

Die Spritzgußform kann zusätzlich mit wenigstens einem Bestükkungsstempel 19 versehen sein.

In die Spritzgußform wird in bekannter Weise der für den Träger 2 und den Reflektor 3 vorgesehene Kunststoff eingespritzt. Die zwischen den Haltestempeln 12, 13 im Hohlraum 20 eingespannte Leiterbahn 9 wird mit diesem Kunststoff umspritzt. Die auf der Leiterbahn 9 befindlichen Leuchtmittel 4 sind während dieses Spritzgußvorganges im Hohlraum 16, 17 der Haltestempel 12, 13 geschützt. Die Haltestempel 12, 13 sind so ausgebildet, daß sie die Leiterbahn 9 nur im unmittelbaren Bereich der Leuchtmittel 4 festklemmen, so daß im übrigen Bereich die Leiterbahn 9 vom Kunststoff für den Träger 2 und den Reflektor 3 umhüllt werden kann. Infolge der Einspannung der Leiterbahn 9 durch die Haltestempel 12, 13 ist sichergestellt, daß die Leuchtmittel 4 ihre exakte Einbaulage am Träger 2 sowie am Reflektor 3 einnehmen. Die flexible, folienartige Leiterbahn 9 selbst muß keine genaue Einbaulage haben, da sie vom Kunststoff des Trägers 2 und des Reflektors 3 umspritzt und damit lagegesichert wird. Nach dem Spritzvorgang wird die Spritzgußform geöffnet, so daß die aus dem Träger 2, dem Reflektor 3 und der eingebetteten Leiterbahn 9 bestehende Einheit herausgenommen und in das Gehäuse 1 eingebaut werden kann. Dadurch gestaltet sich die Herstellung und die Montage der Leuchteneinheit einfach und kostengünstig.

Die Leuchteneinheit kann beispielsweise eine Blinkerleuchte, eine Heckleuchte, eine Scheinwerferleuchte oder allgemein eine Signalleuchte eines Kraftfahrzeuges sein. Die eingebettete Leiterbahn kann aber auch für die Innenraum- und/oder Instrumentenbeleuchtung bei Kraftfahrzeugen eingesetzt werden, beispielsweise als Armaturenleuchte, Cockpitleuchte, Türgriffbeleuchtung und dergleichen.

Auf der in den Kunststoff eingebetteten Leiterbahn 9 können außer Leuchtmitteln beispielsweise auch Sensoren oder andere elektronische und/oder elektrische Bauteile befestigt sein. Die eingebettete Leiterbahn 9 kann außer bei Kraftfahrzeugen beispielsweise auch bei Kameras, akustischen Signalgebern, Handys und dergleichen eingesetzt werden.

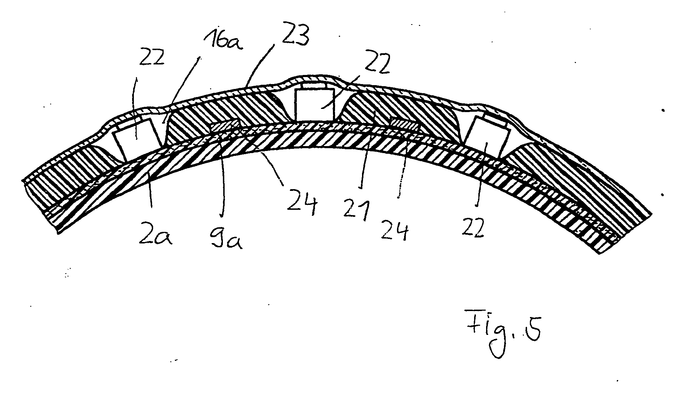

Fig. 5 zeigt eine Leiterbahn 9a, auf der vorzugsweise mit gleichem Abstand voneinander Taster 22 befestigt sind. Die Leiterbahn 9a besteht wie beim zuvor beschriebenen Ausführungsbeispiel aus einer flexiblen Folie, die in einen Träger 2a aus formbeständigen Kunststoff eingebettet ist. Die Taster 22 liegen in Hohlräumen 16a einer auf der Leiterbahn 9a aufgebrachten Kunststoffschicht 21. Sie wird, wie oben beschrieben, in einer Spritzgußform mit den Haltestempeln 12, 13 hergestellt, zwischen denen die Leiterfolie 9a mit den Tastern 22 eingeklemmt ist. Die Kunststoffschicht 21 hat eine an die Höhe der Taster 22 angepaßte Stärke, so daß diese nicht nennenswert über die Kunststoffschicht 21 ragen. Sie ist nach außen von einer Deckfolie 23 abgedeckt, die auch die Taster 22 abdeckt. Die Deckfolie 23 ist relativ dünn. Sie ist mit der Kunststoffschicht 21 fest verbunden, während sie auf den Tastern 22 lose aufliegt und in diesem Bereich flexibel ist. Selbstverständlich kann die Deckfolie 23 auch entfallen. Bei dieser Baueinheit ist die Leiterbahn 9a formstabil, formschlüssig und positionsgenau vom Träger 2a und der Kunststoffschicht 21 umspritzt. Die Baueinheit läßt sich mit wenigen Arbeitsschritten und aus wenigen Einzelteilen einfach und kostengünstig herstellen. Das Bauteil hat nur ein relativ kleines Volumen, so daß es platzsparend untergebracht werden kann. In die Kunststoffschicht 21 sind elektrische/elektronische Bauteile 24 eingespritzt, die auf der Leiterbahn 9a sitzen und zum Betrieb der Taster 22 notwendig sind. Über den flexiblen Bereich der Deckfolie 23 können die Taster 22 einwandfrei betätigt werden. Die Taster 22 können beispielsweise Bestandteil eines Handys, einer Bedieneinheit und dergleichen sein.

Anstelle der Taster 22 können auch Sensoren verwendet werden, beispielsweise Ultraschall-Sensoren als Einparkhilfe bei Kraftfahrzeugen, Sensoren für die Innenraumüberwachung bei Kraftfahrzeugen, Regensensoren und dergleichen. Da die Baueinheit sehr flach baut, kann sie insbesondere im Kraftfahrzeugbereich beispielsweise als Dachmodul-Bedieneinheit, in der Stoßstange als Einparkhilfe oder für Sensoren im Innen- und im Außenbereich eingesetzt werden.

Da die Leiterbahnen 9, 9a von Kunststoff ummantelt sind, ergibt sich eine optimale Wärmeverteilung und Wärmeableitung. Zusätzliche Maßnahmen zur Wärmeverteilung bzw. Wärmeableitung sind darum nicht erforderlich.

Als Kunststoff für den Träger 2 bzw. 2a und/oder den Reflektor 3 bzw. die Kunststoffschicht 21 kommen Thermoplaste, wie Polycarbonat, Acrylnitril-Butadien-Styrol-Copo-lymere (ABS), Polybutylenterephtalat (PBT), Polyamid und dergleichen in Betracht. Thermoplaste haben einen verhältnismäßig niedrigen Schmelzpunkt, so daß beim Spritzgießen des Trägers 2, 2a und des Reflektors 3 oder der Kunststoffschicht 21 keine Gefahr für die auf der Leiterbahn 9, 9a befindlichen elektrischen und/oder elektronischen Bauteile 4 bzw. 22 besteht.

Dem Kunststoff können zur besseren Wärmeableitung Zusatzstoffe beigemischt werden, wie Mineralstoffe, Glas, Mehl, Fasern, Keramiken und dergleichen. Diese Zusatzstoffe können bis zu etwa 60 Gew.-% betragen.

## Patentansprüche

1. Baueinheit für den Einbau in ein Fahrzeug, mit wenigstens einer flexiblen Leiterbahn (9, 9a), auf der sich wenigstens ein elektrisches und/oder elektronisches Bauteil (4) befindet und die von beiden Seiten in ein Kunststoffteil (3, 21) zumindest teilweise durch Umspritzen eingebettet ist, wobei der unmittelbare Bereich des elektrischen und/oder elektronischen Bauteiles (4) frei von Kunststoff ist,
**dadurch gekennzeichnet, dass** die flexible Leiterbahn (9, 9a) eine flexible Leiterfolie ist, die durch die teilweise Einbettung in das Kunststoffteil (21, 23) ihre Formstabilität erhält.

2. Baueinheit nach Anspruch 1,
**dadurch gekennzeichnet, dass** das elektrische und/oder elektronische Bauteil (4) ein Leuchtmittel und das Kunststoffteil (3) als Reflektor für das Leuchtmittel ausgebildet ist.

3. Baueinheit nach Anspruch 1 oder 2,
**dadurch gekennzeichnet, dass** das Leuchtmittel (4) eine LED oder eine SMD ist.

4. Baueinheit nach Anspruch 1,
**dadurch gekennzeichnet, dass** das elektrische und/oder elektronische Bauteil (22) ein Taster ist.

5. Baueinheit nach Anspruch 4,
**dadurch gekennzeichnet, dass** das Bauteil (22) in einem Aufnahmeraum (16a) des Kunststoffteiles (21) angeordnet ist.

6. Baueinheit nach einem der Ansprüche 1 bis 5,
**dadurch gekennzeichnet, dass** das Kunststoffteil (21) und/oder das Bauteil (22) auf seiner Außenseite wenigstens teilweise mit einer Deckschicht (23) abgedeckt ist.

7. Baueinheit nach Anspruch 6,
**dadurch gekennzeichnet, dass** die auf dem Kunststoffteil (21) befestigte Deckschicht (23) durch eine Kunststofffolie gebildet ist.

8. Baueinheit nach Anspruch 6 oder 7,
**dadurch gekennzeichnet, dass** die Deckschicht (23) im Bereich des elektrischen und/oder elektronischen Bauteiles (22) elastisch nachgiebig ausgebildet ist.

9. Baueinheit nach Anspruch 1,
**dadurch gekennzeichnet, dass** das elektrische und/oder elektronische Bauteil (22) ein Sensor ist.

10. Baueinheit nach Anspruch 9,
**dadurch gekennzeichnet, dass** der Sensor (22) Teil einer Einparkhilfe des Kraftfahrzeuges ist.

11. Baueinheit nach Anspruch 9,
**dadurch gekennzeichnet, dass** der Sensor (22) ein Ultraschall- oder Regensensor ist.

12. Baueinheit nach einem der Ansprüche 1 bis 11,
**dadurch gekennzeichnet, dass** die Baueinheit als Teil einer Leuchteneinheit des Kraftfahrzeuges verwendet wird.

13. Baueinheit nach einem der Ansprüche 1 bis 11,
**dadurch gekennzeichnet, dass** die Baueinheit als Dachmodul-Bedieneinheit des Kraftfahrzeuges verwendet wird.

14. Verfahren zur Herstellung einer Baueinheit, bei dem auf eine flexible Leiterbahn (9, 9a) wenigstens ein elektrisches und/oder elektronisches Bauteil (4) aufgebracht wird, bei dem die bestückte Leiterbahn (9, 9a) in eine Spritzgussform gelegt und lagegesichert wird und bei dem die Leiterbahn (9, 9a) in der Spritzgussform wenigstens teilweise von beiden Seiten mit Kunststoff umspritzt wird,
**dadurch gekennzeichnet, dass** als flexible Leiterbahn (9, 9a) eine flexible Leiterfolie eingesetzt wird, die zwischen wenigstens zwei Haltestempeln (12, 13) der Spritzgussform so eingespannt wird, dass der das elektrische und/oder elektronische Bauteil enthaltende Bereich der Leiterfolie (9, 9a) innerhalb eines Hohlraumes (16, 17) wenigstens des einen Haltestempels (12, 13) liegt, wobei der Hohlraum (16, 17) gegenüber dem in die Spritzgussform eingespritzten Kunststoff durch den Haltestempel (12, 13) abgedichtet wird.

## Claims

1. A structural unit for installation in a vehicle, with at least one flexible conductive track (9, 9a) on which at least one electrical and/or electronic component (4) is located and which is embedded from both sides in a plastics-material part (3, 21) at least partially by encapsulating it by injection moulding, the immediate region of the electrical and/or electronic component (4) being free from plastics material, **characterised in that** the flexible conductive track (9, 9a) is a flexible conductor foil which obtains its dimensional stability,by the partial embedding into the plastics-material part (21, 23 [sic]).

2. A structural unit according to Claim 1, **characterised in that** the electrical and/or electronic component (4) is an illuminant and the plastics-material part (3) is designed as a reflector for the illuminant.

3. A structural unit according to Claim 1 or 2, **characterised in that** the illuminant (4) is an LED or an SMD.

4. A structural unit according to Claim 1, **characterised in that** the electrical and/or electronic component (22) is a push-button switch.

5. A structural unit according to Claim 4, **characterised in that** the component (22) is arranged in a receiving space (16a) of the plastics-material part (21).

6. A structural unit according to one of Claims 1 to 5, **characterised in that** the plastics-material part (21) and/or the component (22) is covered at least partially on its outside with a cover layer (23).

7. A structural unit according to Claim 6, **characterised in that** the cover layer (23) fixed to the plastics-material part (21) is formed by a plastics-material film.

8. A structural unit according to Claim 6 or 7, **characterised in that** the cover layer (23) in the region of the electrical and/or electronic component (22) is formed to be elastically yielding.

9. A structural unit according to Claim 1, **characterised in that** the electrical and/or electronic component (22) is a sensor.

10. A structural unit according to Claim 9, **characterised in that** the sensor (22) is part of a parking aid of the motor vehicle.

11. A structural unit according to Claim 9, **characterised in that** the sensor (22) is an ultrasound sensor or rain sensor.

12. A structural unit according to one of Claims 1 to 11, **characterised in that** the structural unit is used as part of a lamp unit of the motor vehicle.

13. A structural unit according to one of Claims 1 to 11, **characterised in that** the structural unit is used as a roof-module operating unit of the motor vehicle.

14. A method for manufacturing a structural unit, in which at least one electrical and/or electronic component (4) is applied to a flexible conductive track (9, 9a), in which the conductive track (9, 9a) with component(s) inserted is laid and secured in position in an injection mould and in which the conductive track (9, 9a) is encapsulated with plastics material at least partially from both sides in the injection mould, **characterised in that** a flexible conductor foil is used as flexible conductive track (9, 9a), which foil is clamped between at least two retaining dies (12, 13) of the injection mould such that the region of the conductor foil (9, 9a) containing the electrical and/or electronic component lies within a cavity (16, 17) of at least the one retaining die (12, 13), the cavity (16, 17) being sealed off from the plastics material injected into the injection mould by the retaining die (12, 13).

## Revendications

1. Sous-groupe de construction destiné à être implanté dans un véhicule et comprenant au moins une bande de circuit imprimé flexible (9, 9a) sur laquelle se trouve au moins un composant (4) électrique et/ou électronique, et qui est encastrée au moins partiellement, sur les deux côtés, par surmoulage par injection, dans une pièce en matière plastique (3, 21), la zone directement occupée par le composant (4) électrique et/ou électronique étant libre de matière plastique, **caractérisé en ce que** la bande de circuit imprimé flexible (9, 9a) est un film de circuit imprimé flexible, dont la stabilité de forme lui est conféré par son encastrement partiel dans la pièce en matière plastique (21, 23).

2. Sous-groupe de construction selon la revendication 1, **caractérisé en ce que** le composant (4) électrique et/ou électronique est un moyen d'éclairage et la pièce en matière plastique (3) est réalisée en tant que réflecteur pour le moyen d'éclairage.

3. Sous-groupe de construction selon la revendication 1 ou la revendication 2, **caractérisé en ce que** le moyen d'éclairage (4) est une diode électroluminescente ou LED ou un composant monté en surface (LED SMD).

4. Sous-groupe de construction selon la revendication 1, **caractérisé en ce que** le composant (22) électrique et/ou électronique est un bouton poussoir ou une touche.

5. Sous-groupe de construction selon la revendication 4, **caractérisé en ce que** le composant (22) est agencé dans un logement de réception (16a) de la pièce en matière plastique (21).

6. Sous-groupe de construction selon l'une des revendications 1 à 5, **caractérisé en ce que** la pièce en matière plastique (21) et/ou le composant (22) est ou sont recouverts au moins partiellement avec une couche de couverture (23).

7. Sous-groupe de construction selon la revendication 6, **caractérisé en ce que** la couche de couverture (23) fixée sur la pièce en matière plastique (21) est un film ou une feuille de matière plastique.

8. Sous-groupe de construction selon la revendication 6 ou la revendication 7, **caractérisé en ce que** la couche de couverture (23) est d'une configuration souple dans la zone du composant (22) électrique et/ou électronique.

9. Sous-groupe de construction selon la revendication 1, **caractérisé en ce que** le composant (22) électrique et/ou électronique est un détecteur.

10. Sous-groupe de construction selon la revendication 9, **caractérisé en ce que** le détecteur (22) est une partie d'un système d'aide au stationnement du véhicule automobile.

11. Sous-groupe de construction selon la revendication 9, **caractérisé en ce que** le détecteur (22) est un détecteur à ultrasons ou un détecteur de pluie.

12. Sous-groupe de construction selon l'une des revendications 1 à 11, **caractérisé en ce que** le sous-groupe de construction est utilisé en tant que partie d'une unité d'éclairage ou de feu du véhicule automobile.

13. Sous-groupe de construction selon l'une des revendications 1 à 11, **caractérisé en ce que** le sous-groupe de construction est utilisé en tant qu'unité de commande de module de toit du véhicule automobile.

14. Procédé de fabrication d'un sous-groupe de construction selon lequel on rapporte sur une bande de circuit imprimé flexible (9, 9a) au moins un composant (4) électrique et/ou électronique, on place et on bloque en position dans un moule de moulage par injection la bande de circuit imprimé flexible (9, 9a) équipée des composants, et on entoure au moins partiellement de matière plastique la bande de circuit imprimé flexible (9, 9a), à partir des deux côtés, par surmoulage, dans le moule de moulage par injection,
**caractérisé en ce que** l'on met en oeuvre en guise de bande de circuit imprimé flexible (9, 9a), un film de circuit imprimé flexible, qui est enserré entre au moins deux poinçons de maintien (12, 13) du moule de moulage par injection, de manière telle que la zone du film de circuit imprimé flexible (9, 9a) contenant le composant électrique et/ou électronique se situe dans une cavité ou un logement en creux (16, 17) d'au moins un poinçon de maintien (12, 13), la cavité ou le logement en creux (16, 17) étant rendu étanche, au moyen du poinçon de maintien (12, 13), à l'encontre de la matière plastique injectée dans le moule de moulage par injection.
